# EUROPÄISCHE PATENTSCHRIFT

(11) **EP 1 118 124 B1**
(45) Veröffentlichungstag und Bekanntmachung des Hinweises auf die Patenterteilung: **01.12.2010**
(21) Anmeldenummer: 99955791.1
(22) Anmeldetag: 20.09.1999
(51) Int. Cl.: H01L 29/732, H01L 21/331

(54) **BIPOLARTRANSISTOR UND VERFAHREN ZU SEINER HERSTELLUNG**
BIPOLAR TRANSISTOR AND METHOD FOR PRODUCING SAME
TRANSISTOR BIPOLAIRE ET SON PROCEDE DE FABRICATION

(30) Priorität: 21.09.1998 DE 19845793
(43) Veröffentlichungstag der Anmeldung: 25.07.2001
(73) Patentinhaber: IHP GmbH-Innovations for High Performance Microelectronics / Leibniz-Institut für innovative Mikroelektronik, 15236 Frankfurt / Oder (DE)
(72) Erfinder: EHWALD, Karl-Ernst, D-15234 Frankfurt (Oder) (DE); TILLACK, Bernd, D-15234 Frankfurt (Oder) (DE); HEINEMANN, Bernd, D-15234 Frankfurt (Oder) (DE); KNOLL, Dieter, D-15230 Frankfurt (Oder) (DE); WOLANSKY, Dirk, D-15234 Frankfurt (Oder) (DE)
(74) Vertreter: Eisenführ, Speiser & Partner
(86) Internationale Anmeldenummer: PCT/DE1999/003072
(87) Internationale Veröffentlichungsnummer: WO 2000/017933

(56) Entgegenhaltungen:
- US-A- 5 137 840
- US-A- 5 604 374
- B.S. MEYERSON: "Low-temperature silicon epitaxy by ultrahigh vacuum/chemical vapor deposition" APPLIED PHYSICS LETTERS., Bd. 48, Nr. 12, 24. März 1986 (1986-03-24), Seiten 797-799, XP000861769 AMERICAN INSTITUTE OF PHYSICS. NEW YORK., US ISSN: 0003-6951

## Beschreibung

Die Erfindung bezieht sich auf ein Verfahren zur Herstellung eines Bipolartransistors gemäß dem Oberbegriff des Anspruchs 1.

Ein bekannter Bipolartransistor und ein Herstellungsverfahren ist in US 5,604,374 beschrieben. Ein wichtiges Einsatzgebiet vertikaler Bipolartransistoren sind Hochgeschwindigkeitsanwendungen. Um die Leistungsfähigkeit der Transistoren im Bereich höchster Geschwindigkeiten zu verbessern, ist der Einfluß parasitärer Komponenten, d. h. Widerstände oder Kapazitäten, zu reduzieren. Daher sind sowohl möglichst leitfähige Verbindungen zwischen den Metallkontakten und der aktiven (inneren) Transistorregion als auch eine minimierte passive Transistorfläche erforderlich.

Um diese Forderungen zu erfüllen, werden lateral skalierte, sogenannte "Doppel-Poly-Silizium-Technologien" in modernen Verfahren zur Herstellung von vertikalen Bipolartransistoren eingesetzt. In solchen Technologien ist es möglich, den Basiskontakt und Teile der hochleitfähigen Poly-Silizium-Verbindung zwischen Kontakt und innerer Basis über isolierten Gebieten anzuordnen. Allerdings sind diese konstruktiven Vorteile gegenüber "Einfach-Poly-Silizium-Technologien" mit solchen Nachteilen wie zusätzlicher Prozeßkomplexität und erhöhten Kontaktwiderständen verbunden. Diese Nachteile stehen im Zusammenhang mit der erforderlichen Ätzung des Poly-Siliziums im aktiven Transistorbereich sowie der Diffusion von Dotanden aus der hochdotierten Poly-Silizium-Schicht in das einkristalline Basisanschlußgebiet. Da das Poly-Silizium für den Basisanschluß über dem aktiven Transistorgebiet mit Hilfe von Trockenätztechniken entfernt wird und keine Selektivität zum darunterliegenden einkristallinen Silizium besteht, kommt es zu Schädigungen der freigelegten Silizium-Oberfläche. Oberflächenrauhigkeit, Störungen der Gitterstruktur und Eindringen von Fremdstoffen sind die Folge.

Es sind verschiedene Ansätze vorgestellt worden, um diese Probleme zu überwinden.

Zum Beispiel werden Ätzstoppschichten zum Schutz der Emitterregion eingesetzt, um Probleme beim Trockenätzen zu lösen. Zusätzlicher Aufwand ist nötig, um eine Selbstjustage von Emittergebiet und Ätzstoppschicht zu gewährleisten.

Durch den Einsatz epitaktischer Prozesse konnten neuerdings die Hochgeschwindigkeits eigenschaften weiter verbessert werden. Dabei wird die in-situ Dotierung während der Abscheidung genutzt, um geringere Basisweiten, d. h. geringere Dicken der Basisschichten und geringere Basisschichtwiderstände, zu erreichen.

Einen zusätzlichen Freiheitsgrad bei der Einstellung von Basisschichtwiderstand und Stromverstärkung und damit zur Optimierung der Hochgeschwindigkeitseigenschaften gewinnt man durch die Abscheidung von Heteroschichten.

Das Konzept einer Doppel-Poly-Silizium-Technologie mit Ätzstoppschicht ist auch im Falle epitaktisch eingebrachter Basisschichten mit Hilfe der sogenannten selektiven Epitaxie verwirklicht worden. Bei der selektiven Epitaxie wird durch die Abscheidebedingungen sichergestellt, daß nur auf unbedeckten Halbleiteroberflächen epitaktisches Wachstum eintritt. Verwendet man differentielle Epitaxie, bei der Siliziummaterial sowohl auf Halbleiter- als auch auf Isolationsgebieten abgeschieden wird, können gleichzeitig die innere Basis und die Verbindung zu einem auf Isolatorgebiet befindlichen Basiskontakt (Basisanschlußgebiet) erzeugt werden. Damit entfällt im allgemeinen die Notwendigkeit für eine zusätzliche Poly-SiliziumSchicht. Die resultierende quasi Doppel-Poly-Silizium-Anordnung erlaubt, den Prozeß zu vereinfachen.

Gegenüber einem vollständigen Doppel-Poly-Prozeß ist man jedoch mit dem Nachteil konfrontiert, daß man die Dicke der Epitaxieschicht im aktiven Transistorbereich nicht unabhängig von der Dicke der Siliziumschicht im Basisanschlußgebiet bzw. auf den Isolatorgebieten einstellen kann. Bedingt durch die schlechte Bekeimung der üblicherweise verwendeten SiO₂-Schicht als Isolatorschicht ist die polykristalline Schicht in der Regel dünner als die epitaktisch gewachsene Schicht. Bezüglich der Epitaxieschichtdicke ergeben sich zwei unterschiedliche Forderungen. Innerhalb des Emitterbereiches sollte eine hinreichend geringe Schichtdikke zwischen dem hochdotierten Emitter und der Basis vorhanden sein. Im äußeren Basisgebiet ist eine größere Dicke von Vorteil, um geringe Widerstände des Basisanschlusses zu ermöglichen.

Aus der US 5,137,840 ist die differentielle Epitaxie einer einkristallinen Schicht im aktiven Transistorbereich über dem Kollektorbereich und einer polykristallinen Schicht auf dem Isolatorbereich bei Temperaturen zwischen 500°C und 800°C bekannt.

Aufgabe der Erfindung ist es, ein Verfahren zur Herstellung eines Bipolartransistors vorzuschlagen, bei dem für eine Einfach-Poly-Silizium-Technologie mit differentieller Epitaxie zur Basisherstellung die beschriebenen Nachteile konventioneller Anordnungen überwunden werden, um insbesondere die Hochgeschwindigkeitseigenschaften eines Bipolartransistors weiter zu verbessern, sehr gut leitfähige Verbindungen zwischen den Metallkontakten und der aktiven (inneren) Transistorregion sowie eine minimierte passive Transistorfläche herzustellen, gleichzeitig zusätzliche Prozeßkomplexität und erhöhte Kontaktwiderstände zu vermeiden.

Erfindungsgemäß wird diese Aufgabe dadurch gelöst, daß bei der Abscheidung die Poly-Silizimschicht auf dem Isolatorgebiet durch Einstellung geeigneter Epitaxiebedingungen mit größerer Dicke abgeschieden wird als die Epitaxieschicht im aktiven Transistorbereich. Die größere Dicke der Poly-Siliziumschicht im Vergleich zur Epitaxieschicht wird erreicht durch die Verwendung einer sehr geringen Temperatur für die Abscheidung eines Teils oder der ganzen Pufferschicht. Anstatt einer Poly-Siliziumschicht liegt auch die Verwendung einer amorphen Siliziumschicht im Bereich der Erfindung. Durch die Verwendung einer sehr geringen Abscheidetemperatur wird eine bessere Bekeimung der Isolatorschicht und eine Verringerung der Totzeit für die Abscheidung erreicht. Die Abscheidung bei sehr geringer Temperatur ermöglicht eine größere Abscheiderate für die polykristalline oder amorphe Schicht im Vergleich zur epitaktischen Schicht. Damit ist es möglich, auf der Isolatorschicht gegenüber dem aktiven Transistorbereich eine größere Schichtdicke einzustellen.

Ein Einfach-Poly-Silizium-Bipolanransistor mit epitaktisch hergestellter Basis gemäß der Erfindung erlaubt eine Reduktion der externen Basiswiderstände, ohne eine Verschlechterung der Emittereigenschaften in Kauf nehmen zu müssen. Bedingt durch die unterbrechungsfreie Abscheidung von innerem und äußerem Basisanschluß treten keine Grenzflächenprobleme beim Basisanschluß auf.

Die Merkmale der Erfindung gehen außer aus den Ansprüchen auch aus der Beschreibung und den Zeichnungen hervor, wobei die einzelnen Merkmale jeweils für sich allein oder zu mehreren in Form von Unterkombinationen schutzfähige Ausführungen darstellen, für die hier Schutz beansprucht wird. Vorzugsweise wird beim Herstellungsverfahren in die Basisschicht Kohlenstoff oder Sauerstoff als ein diffusionshemmendes Mittel für die Basisdotierung eingebaut. Die Erfindung führt auf einen Bipolartransistor mit auf einer einkristallinen Substratschicht angeordneten strukturierten Gebieten, bestehend aus einem Kollektorbereich, sowie diesen umgebenden Isolationsgebieten und einer über dem Kollektorbereich und den Isolationsgebieten angeordneten Schichtfolge aus Silizium, die einkristallin über dem Kollektorbereich und polykristallin oder amorph auf den diesen umgebenden Isolationsgebieten ist. Dabei ist erfindungsgemäß vorgesehen, daß
- die Schichtfolge eine zuerst abgeschiedene Pufferschicht und eine danach abgeschiedene Basisschicht aufweist;
- jede Schicht des polykristallinen oder amorphen Teils der Schichtfolge über den Isolationsgebieten lateral an eine jeweilige Schicht des einkristallinen Teils der Schichtfolge über dem Kollektorbereich anschließt, und daß
- die Dicke der amorphen oder polykristallinen Schichtfolge auf den Isolationsgebieten größer ist als die Dicke der einkristallinen Schicht im aktiven Transistorbereich über dem Kollektorbereich und damit keine Grenzflächenkontamination zwischen der Basisschicht in der einkristallinen Schichtfolge im aktiven Transistorbereich und dem Basisanschluß bestehend aus der amorphen oder polykristallinen Schichtfolge auf den Isolationsgebieten vorhanden ist.

Vorzugsweise besteht die einkristalline Schichtfolge über dem Kollektorgebiet aus der Pufferschicht, einer dotierten Basisschicht und einer über der Basisschicht angeordneten Deckelschicht.

Ausführungsbeispiele der Erfindung sind in den Zeichnungen dargestellt und werden im Folgenden näher erläutert.

Die Zeichnungen zeigen:
- Fig. 1: Schematische Darstellung eines Bipolartransistors
- Fig. 2: Schematische Darstellung eines Bipolartransistors nach Fig. 1 während der Herstel- lung

Die Erfindung wird nun im Zusammenhang mit einem Einfach-Poly-Silizium-Prozeß mit epitaktisch erzeugter Basis beschrieben.

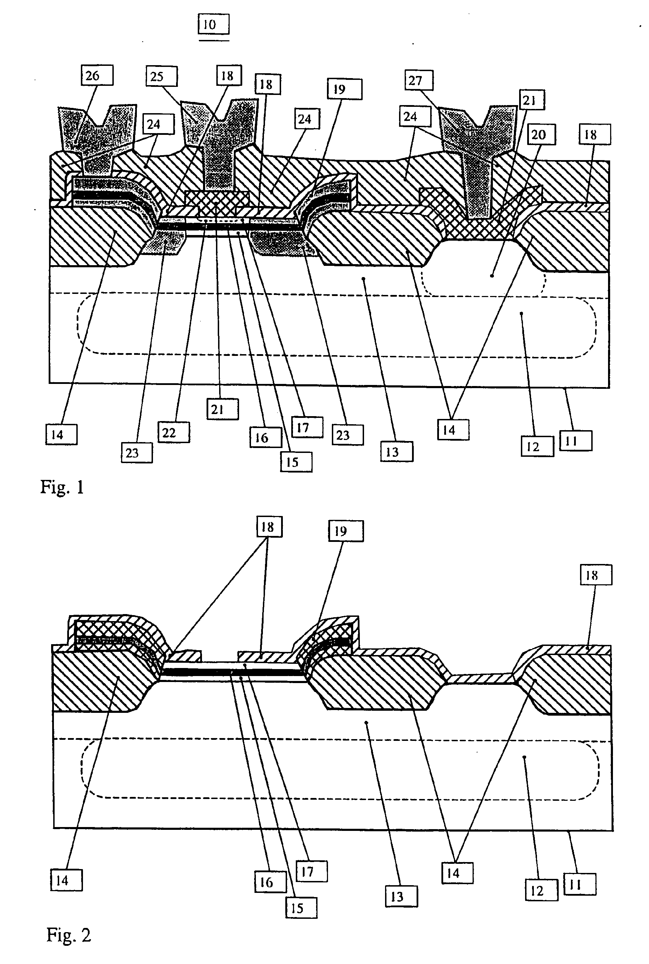

Fig. 1 zeigt schematisch einen Bipolartransistor **10**, der gemäß der Erfindung hergestellt werden kann. Auf dem halbleitenden Substratgebiet **11** vom Leitfähigkeitstyp I ist ein Kollektorgebiet vom Leitfähigkeitstyp **II** erzeugt worden. Sind Emitter und Kollektor z. B. n-leitend, ist die Basis vom p-Typ bzw. umgekehrt. Es sind mehrere Verfahren bekannt, die eine geeignete Kollektordotierung liefern. Dazu zählen zum Beispiel der in Fig. 1 gezeigte Aufbau mit einer hochdotierten, vergrabenen Schicht **12** und einer schwächer dotierten Epitaxieschicht **13,** aber auch implantierte retrograde Wannen. Ein Feldisolationsgebiet **14** trennt im hier dargestellten Beispiel den Bipolartransistor von anderen, in der Fig. nicht dargestellten Bauelementen und auch den Kollektoranschlußbereich vom aktiven Transistorgebiet. Es sind auch andere geeignete Isolationstechniken bekannt, wie z. B. verspacerte Mesa-Anordnungen. Wahlweise kann ein Schachtimplant **20** eingesetzt werden, um den Widerstand zwischen der aus hochdotiertem Poly-Silizium bestehenden Kontaktschicht **21** und der vergrabenen Schicht **12** zu verringern.

Eine Epitaxieschichtfolge, bestehend aus Pufferschicht **15,** in-situ dotierter Basisschicht **16** vom Leitfähigkeitstyp I sowie aus der Deckelschicht **17,** bedeckt die Emitterregion im aktiven Transistorbereich und mindestens einen Teil des Isolationsgebietes. Die außerhalb des aktiven Transistorgebietes strukturierte Epitaxieschicht ist mit einem Dielektrikum **18** bedeckt.

Als wesentlich im Sinne der Erfindung ist die Verwendung einer dicken polykristallinen Schicht **19** auf dem Isolatorgebiet. Anstatt einer polykristallinen Schicht **19** ist in Abwandlung dazu auch eine amorphe Schicht verwendbar. Die speziellen Werte für die Dicke, den Dotandengehalt sowie die Materialzusammensetzung der Basis sind entsprechend den Erfordernissen der Funktion des Bipolartransistors einzustellen und unterliegen bezüglich dem Wesen der Erfindung keinen besonderen Anforderungen. Im dargestellten Beispiel besteht die Basisschicht aus Silizium, ist mit 2x10¹⁸ cm⁻³ p-dotiert und sei 40 nm dick. Es können aber auch andere Materialkompositionen und Dotierungsprofile verwendet werden. Der Einsatz einer dünnen Deckelschicht 17 über der Basisschicht ist möglich, aber nicht wesentlich für die vorliegende Erfindung. Die Dotierung des Emitters im einkristallinen Silizium wird durch Ausdiffusion von Dotierstoff 22 aus der hochdotierten Poly-Silizium-Kontaktschicht 21 sichergestellt. Die abgeschiedene Dicke der Deckelschicht kann typischerweise 50 nm betragen.

Während die Puffer-, Basis- und Deckelschicht einkristallin über dem Silizium-Substrat wachsen, entstehen polykristalline Schichten 19 über dem Isolationsgebiet 14. Die Dicke der abgeschiedenen polykristallinen Schicht ist größer als die der einkristallinen Schicht. Außerhalb der den aktiven Transistorbereich überlappenden Poly-Silizium-Kontaktschicht 21 ist die Dotierung im Basisanschlußgebiet zusätzlich durch Implantation 23 vergrößert worden. Die Isolationsschicht 24 trennt Emitter-, Basis- und Kollektorkontakt. Vervollständigt wird der Transistoraufbau durch Metallkontakte für Emitter 25, Basis 26 und Kollektor 27.

### Heranführendes Beispiel zum besseren Verständnis der Erfindung

Ausgangspunkt für das Verfahren ist der in Fig. 2 dargestellte Aufbau. In p-dotiertes Silizium-Substrat 11 wird nach photolithographischer Strukturierung eine hochdotierte n-Schicht 12 per Implantation eingebracht und ausgeheilt. Anschließend wird epitaktisch eine schwach dotierte n-Schicht 13 abgeschieden. Übliche Prozeßschritte definieren das aktive Gebiet und erzeugen in den verbleibenden Gebieten Isolationsgebiete 14 (z. B. LOCOS). Mit Hilfe der differentiellen Epitaxie wird zuerst die Pufferschicht 15 bei sehr niedriger Temperatur abgeschieden. Ein typischer Wert für die Abscheidetemperatur ist 550 °C. Bei dieser Temperatur wird die Keimbildung auf dem Isolatorgebiet verbessert und die Totzeit verringert. Die Abscheiderate der polykristallinen Schicht ist größer als die der epitaktischen Schicht. Danach erfolgt die Abscheidung der Basisschicht 16 und der Deckelschicht 17. Als Resultat ist die polykristalline Schicht 19 auf dem Isolator dicker als die einkristalline Schicht im aktiven Transistorgebiet.

Nach photolithographischer Strukturierung einer Maske werden mit Hilfe eines Plasmaätzschrittes außerhalb des späteren Transistor- und Basisanschlußgebietes die abgeschiedenen Silizium- bzw. Poly-Silizium-Schichten mit Ätzstopp auf dem Isolationsgebiet entfernt. Anschließend wird ein Dielektrikum 18, vorzugsweise Oxid, aufgebracht. Durch photolithographische Strukturierung einer Lackmaske wird nun das Kollektoranschlußgebiet freigelegt und der Schachtimplant 20 eingebracht. Nach dem Entfernen dieser Lackmaske und der Strukturierung einer weiteren Lackmaske wird im Kollektoranschlußgebiet wie auch im Emitterbereich die Oxidschicht (Dielektrikum 18) vorzugsweise naßchemisch geätzt. Der Prozeß wird fortgesetzt mit der Abscheidung einer amorphen Siliziumschicht. Diese kann bereits in-situ während oder im Anschluß an die Abscheidung durch Implantation dotiert werden. Mit einem Lithographieschritt werden Emitter- und Kollektorkontaktgebiet maskiert. In den übrigen Gebieten wird das amorphe Silizium bei einem Plasmaätzschritt mit Stopp auf der SiO₂-Schicht entfernt. Bei der anschließenden Implantation der Basisanschlußgebiete werden Emitter- und Kollektorkontaktbereich durch die vorhandene Maskierung geschützt. Nach Entfernen der Maskierung und Abdeckung der entstandenen Oberfläche mit Oxid folgt eine Temperung zur Ausheilung der Implantationsschäden sowie zur Formierung des Poly-Emitters. Der Prozeß wird vervollständigt durch das Öffnen der Kontaktlöcher für Emitter, Basis und Kollektor und eine Standardmetallisierung für die Transistorkontakte.

Im folgenden wird die Herstellung eines Bipolartransistors gemäß der Erfindung in einem Beispiel dargelegt.

### Erfindungsgemäßes Beispiel:

Ausgangspunkt für das erfindungsgemäße Verfahren ist der in Fig. 2 dargestellte Aufbau. In p-dotiertes Silizium-Substrat 11 wird nach photolithographischer Strukturierung eine hochdotierte n-Schicht 12 per Implantation eingebracht und ausgeheilt. Anschließend wird epitaktisch eine schwach dotierte n-Schicht 13 abgeschieden. Übliche Prozeßschritte definieren das aktive Gebiet und erzeugen in den verbleibenden Gebieten Isolationsgebiete 14 (z. B. LOCOS). Mit Hilfe der differentiellen Epitaxie wird zuerst die Pufferschicht 15 in zwei Schritten abgeschieden. Im ersten Schritt wird eine sehr niedrige Abscheidetemperatur verwendet. Ein typischer Wert für die verwendete Temperatur ist 550 °C. Bei dieser Temperatur wird die Keimbildung auf dem Isolatorgebiet verbessert und die Totzeit verringert. Die Abscheiderate der polykristallinen Schicht ist größer als die der epitaktischen Schicht. Nach Abscheidung des ersten Teils der Pufferschicht wird das Wachstum der Pufferschicht bei gleicher oder auch bei erhöhter Temperatur (typische Temperatur ist 650°C) fortgesetzt. Danach erfolgt die Abscheidung der Basisschicht **16** und der Deckelschicht **17**. Als Resultat ist die polykristalline Schicht **19** auf dem Isolator dicker als die einkristalline Schicht im aktiven Transistorgebiet.

Nach photolithographischer Strukturierung einer Maske werden mit Hilfe eines Plasmaätzschrittes außerhalb des späteren Transistor- und Basisanschlußgebietes die abgeschiedenen Silizium- bzw. Poly-Silizium-Schichten mit Ätzstopp auf dem Isolationsgebiet entfernt. Anschließend wird ein Dielektrikum **18,** vorzugsweise Oxid, aufgebracht.

Durch photolithographische Strukturierung einer Lackmaske wird nun das Kollektoranschlußgebiet freigelegt und der Schachtimplant **20** eingebracht. Nach dem Entfernen dieser Lackmaske und der Strukturierung einer weiteren Lackmaske wird im Kollektoranschlußgebiet wie auch im Emitterbereich die Oxidschicht (Dielektrikum **18**) vorzugsweise naßchemisch geätzt. Der Prozeß wird fortgesetzt mit der Abscheidung einer amorphen Siliziumschicht. Diese kann bereits in-situ während oder im Anschluß an die Abscheidung durch Implantation dotiert werden. Mit einem Lithographieschritt werden Emitter- und Kollektorkontaktgebiet maskiert. In den übrigen Gebieten wird das amorphe Silizium bei einem Plasmaätzschritt mit Stopp auf der SiO₂-Schicht entfernt. Nach Abdeckung der entstandenen Oberfläche mit Oxid folgt eine Temperung zur Ausheilung der Implantationsschäden sowie zur Formierung des Poly-Emitters. Der Prozeß wird vervollständigt durch das Öffnen der Kontaktlöcher für Emitter, Basis und Kollektor und eine Standardmetallisierung für die Transistorkontakte.

In der vorliegenden Erfindung wurde anhand eines konkreten Ausführungsbeispiels ein Verfahren zur Herstellung eines Bipolartransistors erläutert. Es sei aber vermerkt, daß die vorliegende Erfindung nicht auf die Einzelheiten der Beschreibung in dem Ausführungsbeispiel eingeschränkt ist, da im Rahmen der Patentansprüche Änderungen und Abwandlungen beansprucht werden, da insbesondere Modifikationen dieses Prozesses, wie z. B. Hetero-Epitaxie, oder die Einbindung in eine Bipolar-CMOS-(BiCMOS)-Technologie ebenfalls möglich sind.

## Patentansprüche

1. Verfahren zur Herstellung eines Bipolartransistors mittels differentieller Epitaxie, bei dem auf einer einkristallinen Silizium-Substratschicht strukturierte Gebiete, bestehend aus einem Kollektorbereich, sowie diesen umgebende Isolationsgebiete erzeugt werden und über dem Kollektorbereich und den Isolationsgebieten eine Schichtfolge aus Silizium abgeschieden wird, die einkristallin über dem Kollektorbereich und polykristallin oder amorph auf den diesen umgegebenden Isolationsgebieten ist, **dadurch gekennzeichnet, daß** bei der differentiellen Epitaxie die amorphe oder polykristalline Schichtfolge (19) auf den Isolationsgebieten (14) durch Einstellung der Epitaxiebedingungen mit größerer Dicke abgeschieden wird als die einkristalline Schichtfolge im aktiven Transistorbereich über dem Kollektorbereich, wobei die differentielle Epitaxie zur Abscheidung der einkristallinen Schichtfolge im aktiven Transistorbereich über dem Kollektorbereich und der polykristallinen oder amorphen Schichtfolge auf den Isolationsgebieten mit der Erzeugung eines ersten Teils einer Pufferschicht (15) bei sehr geringer Temperatur von 550 °C beginnt und die weitere Abscheidung der Pufferschicht (15) bei höherer Temperatur fortgesetzt wird und danach die Basisschicht (16) abgeschieden wird und somit keine Grenzflächenkontamination zwischen der Basisschicht (16) in der einkristallinen Schichtfolge im aktiven Transistorbereich und dem Basisanschluß bestehend aus der amorphen oder polykristallinen Schichtfolge auf den Isolationsgebieten (14) vorhanden ist.

2. Verfahren nach Anspruch 1, **dadurch gekennzeichnet, daß** die weitere Abscheidung der Pufferschicht (15) nach Erzeugung des ersten Teils bei höheren Temperaturen im Bereich von 600 °C bis 800 °C erfolgt.

3. Verfahren nach Anspruch 2, **dadurch gekennzeichnet, daß** die weitere Abscheidung der Pufferschicht (15) nach Erzeugung des ersten Teils bei einer Temperatur von 650°C erfolgt.

4. Verfahren nach einem der vorhergehenden Ansprüche, **dadurch gekennzeichnet, daß** in die Basisschicht Kohlenstoff oder Sauerstoff als ein diffusionshemmendes Mittel für die Basisdotierung eingebaut ist.

## Claims

1. Method of producing a bipolar transistor by differential epitaxy, wherein structured areas consisting of a collector region, and insulation areas surrounding it, are produced on a monocrystalline silicon substrate layer and a sequence of layers of silicon is deposited over the collector region and the insulation areas, this layer sequence being monocrystalline over the collector region and polycrystalline or amorphous on the insulation areas surrounding it, **characterised in that** in the differential epitaxy, by adjustment of the epitaxy conditions, the amorphous or polycrystalline layer sequence (19) is deposited to a greater thickness on the insulation areas (14) than the monocrystalline layer sequence in the active transistor region over the collector region, wherein, for the depositing of the monocrystalline layer sequence in the active transistor region over the collector region and of the polycrystalline or amorphous layer sequence on the insulation areas, the differential epitaxy starts with the production of a first part of a buffer layer (15) at a very low temperature of 550°C and the further deposition of the buffer layer (15) is continued at higher temperature and then the base layer (16) is deposited and thus there is no interfacial contamination between the base layer (16) in the monocrystalline layer sequence in the active transistor region and the base connection consisting of the amorphous or polycrystalline layer sequence on the insulation areas (14).

2. Method according to claim 1, **characterised in that** the further deposition of the buffer layer (15) after the production of the first part takes place at higher temperatures in the range from 600°C to 800°C.

3. Method according to claim 2, **characterised in that** the further deposition of the buffer layer (15) after the production of the first part takes place at a temperature of 650°C.

4. Method according to one of the preceding claims, **characterised in that** carbon or oxygen is incorporated in the base layer as a diffusion-inhibiting agent for the base doping.

## Revendications

1. Procédé de fabrication d'un transistor bipolaire vertical, au moyen d'une épitaxie différentielle, dans lequel, sur une couche de substrat en silicium monocristalline, des domaines structurés, composés d'une zone de collecteur, ainsi que des domaines d'isolation entourant celle-ci sont fabriqués, et au-dessus de la zone de collecteur et les domaines d'isolation étant déposés une succession de couches en silicium, monocristalline au-dessus de la zone de collecteur et polycristalline ou amorphe sur les domaines d'isolation entourant celle-ci, **caractérisé en ce que**, lors de l'épitaxie différentielle, la succession de couches (19), amorphe ou polycristalline, est déposée sur les domaines d'isolation (14) par réglage des conditions d'épitaxie avec une plus grande épaisseur que la succession de couches monocristalline dans la zone de transistor active au-dessus de la zone de collecteur, l'épitaxie différentielle pour la déposition de la succession de couches monocristalline dans la zone de transistor active au-dessus de la zone de collecteur et la succession de couches polycristalline ou amorphe sur les domaines d'isolation commençant avec la production de la première partie d'une couche tampon (15) à une température très faible de 550°C et la continuation de la déposition de la couche tampon (15) étant continuée à une température plus élevée et, ensuite, la couche de base (16) est déposée et, ainsi, il n'y a aucune contamination des surfaces limites entre la couche de base (16) dans la succession de couches monocristalline, dans la zone de transistor active, et le raccordement de base composé de la succession de couches amorphe ou polycristalline, sur les domaines d'isolation (14).

2. Procédé selon la revendication 1, **caractérisé en ce que** la suite de la déposition de la couche tampon (15) s'effectue après production de la première partie, à des températures plus élevées, dans la fourchette allant de 600°C à 800°C.

3. Procédé selon la revendication 2, **caractérisé en ce que** la suite de la déposition de la couche tampon (15) s'effectue après production de la première partie, à une température de 650°C.

4. Procédé selon l'une quelconque des revendications précédentes, **caractérisé en ce que** du carbone ou de l'oxygène est intégré dans la couche de base comme moyen d'inhibition de la diffusion pour le dopage de la base.
